# EUROPÄISCHE PATENTANMELDUNG

(11) **EP 4 585 885 A1**
(43) Veröffentlichungstag der Anmeldung: **16.07.2025**
(21) Anmeldenummer: 25150873.5
(22) Anmeldetag: 09.01.2025
(51) Int. Cl.: G01D 11/24, H05K 5/02, F21W 111/00, G09F 13/04

(54) **GEHÄUSEBAUGRUPPE MIT RUNDUM SICHTBAREN LEUCHTFLÄCHEN**

(30) Priorität: 09.01.2024 DE 202024100086 U
(71) Anmelder: Murrelektronik GmbH, 71570 Oppenweiler (DE)
(72) Erfinder: Roolf, Tim, 71570 Oppenweiler (DE); Feißt, Heiko, 71570 Oppenweiler (DE); Maier, Jan, 71570 Oppenweiler (DE); Ruf, Henrik, 71570 Oppenweiler (DE)
(74) Vertreter: Prinz & Partner mbB

(57) **Zusammenfassung**

Die Erfindung betrifft eine Gehäusebaugruppe für ein elektronisches Gerät (10), mit einer Anschlussseite (20), an der wenigstens ein Anschluss (22) vorgesehen ist, einer ersten Längsseite (24), einer zweiten Längsseite (26), einer ersten Stirnseite (28) und einer zweiten Stirnseite (30). Die Seiten (20, 24, 26, 28, 30) weisen jeweils zumindest eine Gehäusewand (32) auf. Die Gehäusebaugruppe (12) hat zumindest zwei Leuchtanzeigen (38) mit einer Leuchtfläche (40) aufweist. Die Leuchtflächen (40) sind entlang der Gehäusebaugruppe (12) derart verteilt angeordnet, dass die Leuchtflächen (40) zusammen in einem aktivierten Zustand Lichtsignale zumindest in einen halbkugelförmigen Bereich (42) um die Gehäusebaugruppe (12) aussenden. Ferner ist ein elektronisches Gerät beschrieben.

## Beschreibung

Die Erfindung betrifft eine Gehäusebaugruppe für ein elektronisches Gerät. Ferner betrifft die Erfindung ein elektronisches Gerät.

In modernen Maschinen und/oder Anlagen werden häufig eine Vielzahl elektronischer Geräte verbaut, beispielsweise als Sensoren oder Aktuatoren oder allgemein als Infrastrukturkomponenten.

Diese Geräte verfügen typischerweise über Leuchtanzeigen, mittels denen Informationen über den jeweiligen Gerätestatus ausgegeben werden, beispielsweise anhand von Lichtfarben des von den Leuchtanzeigen ausgesendeten Lichts oder Lichtfolgen bzw. Lichtmustern. Dabei gibt es Normen und Richtlinien, beispielsweise die IEC61131 oder die Maschinenrichtlinie, welche die Lichtfarben vorgeben.

Oft wird der Status von Eingängen und Ausgängen mit grünem, blauem oder orangem Licht angezeigt. Hingegen werden Störungen zumeist über rotes Licht symbolisiert.

In vielen Maschinen und/oder Anlagen stehen daher an unterschiedlichen Positionen eine Vielzahl optischer Signale bzw. Informationen zur Verfügung, was zu Unübersichtlichkeiten führen kann und es schwierig macht, ein spezifisches elektronisches Gerät zu identifizieren.

Die Sichtbarkeit der Leuchtanzeigen kann je nach Einbausituation des elektronischen Geräts eingeschränkt sein, sodass ein Nutzer das über die Leuchtanzeige ausgesandte Licht nicht oder nur eingeschränkt wahrnehmen kann. Dies ist insbesondere dann kritisch, wenn eine Störung angezeigt wird, die behoben werden soll. In diesem Fall ist es wünschenswert, dass der Nutzer schnell das entsprechende elektronische Gerät identifizieren kann, um die Störung zu beheben. Aber auch andere Szenarien können in diesem Zusammenhang relevant sein.

Es muss also ein Kompromiss zwischen der guten Sichtbarkeit von wichtigen optischen Signalen und der grundsätzlichen Übersichtlichkeit in einer Anlage gefunden werden, da zu viele optische Signale schnell zur Unübersichtlichkeit führen können.

Die Aufgabe der Erfindung ist es, die aus dem Stand der Technik bekannten Nachteile auf einfache und kostengünstige Weise zu beheben.

Die Aufgabe wird erfindungsgemäß gelöst durch eine Gehäusebaugruppe für ein elektronisches Gerät, mit einer Anschlussseite, an der wenigstens ein Anschluss vorgesehen ist, einer ersten Längsseite, einer zweiten Längsseite, einer ersten Stirnseite und einer zweiten Stirnseite. Die Seiten weisen dabei jeweils zumindest eine Gehäusewand auf. Die Längsseiten sind jeweils mit den Stirnseiten in Übergangsbereichen verbunden. Die Gehäusebaugruppe hat außerdem zumindest zwei Leuchtanzeigen, wobei jede der Leuchtanzeigen zumindest eine Leuchtfläche aufweist und wobei eine erste der zumindest zwei Leuchtanzeigen in einem ersten Übergangsbereich vorgesehen ist und eine zweite der zumindest zwei Leuchtanzeigen in einem zweiten Übergangsbereich vorgesehen ist, der vom ersten Übergangsbereich unterschiedlich ist. Die Leuchtflächen sind dabei entlang der Gehäusebaugruppe derart verteilt angeordnet, dass die Leuchtflächen zusammen in einem aktivierten Zustand Lichtsignale zumindest in einen halbkugelförmigen Bereich um die Gehäusebaugruppe aussenden.

Dadurch wird eine gute Sichtbarkeit dieser Leuchtflächen bei einer Betrachtung der Anschlussseite des elektronischen Geräts gewährleistet. Gleichzeitig können die Leuchtflächen aber auch bei einer Betrachtung der ersten Längsseite, der zweiten Längsseite, der ersten Stirnseite und/oder der zweiten Stirnseite des elektronischen Geräts gesehen werden und so ihren Zweck der Signalisierung erfüllen. Mit anderen Worten ergibt sich eine Rundumsichtbarkeit der Leuchtflächen (360°-Sichtbarkeit) bei einer seitlichen Betrachtung des elektronischen Geräts.

Licht, das von den Leuchtflächen ausgesendet wird, kann so jeden Punkt einer durch den halbkugelförmigen Bereich definierten Halbkugeloberfläche erreichen, welcher die Gehäusebaugruppe umgibt.

Daher kann auch wenigstens eine der Leuchtflächen von jedem Punkt der die Gehäusebaugruppe umgebenden Halbkugeloberfläche aus gesehen werden, also ein entsprechendes Lichtsignal, das von der wenigstens einen der Leuchtflächen ausgesandt worden ist.

Mit anderen Worten sind die Leuchtflächen entlang der Gehäusebaugruppe derart verteilt angeordnet, dass sie zusammen in einem aktivierten Zustand Lichtsignale zumindest in den halbkugelförmigen Bereich um die Gehäusebaugruppe so aussenden, dass die Lichtsignale von jedem Punkt der durch den halbkugelförmigen Bereich definierten Halbkugeloberfläche aus wahrgenommen werden können.

Es gibt also eine direkte Sichtlinie zwischen jedem Punkt der durch den halbkugelförmigen Bereich definierten Halbkugeloberfläche und zumindest einem Punkt auf einer der Leuchtflächen.

Dadurch können Informationen über den Zustand des elektronischen Geräts besser zugänglich gemacht und prägnanter dargestellt werden, beispielswiese um Wartungspersonal anzuzeigen, ob und wo eine Störung der Maschine und/oder Anlage vorliegt und/oder eine Wartung notwendig ist.

Grundsätzlich kann die durch den halbkugelförmigen Bereich um die Gehäusebaugruppe definierte Halbkugeloberfläche einen beliebigen Abstand zur Gehäusebaugruppe haben. Mit "Abstand" ist hierbei insbesondere die Distanz zwischen dem Zentrum der Gehäusebaugruppe oder einer Oberfläche der Gehäusebaugruppe zur Halbkugeloberfläche gemeint, wobei das Zentrum der Gehäusebaugruppe die Kugelmitte des halbkugelförmigen Bereichs bildet. Beispielsweise beträgt der Abstand der Halbkugeloberfläche zur Gehäusebaugruppe 10 cm, 50 cm, 1 m, 5 m, 10 m, 50 m oder 100 m. Zumindest von diesem Abstand aus können die Leuchtflächen bzw. die von den Leuchtflächen ausgesendeten Lichtsignale von jedem Punkt der Halbkugeloberfläche aus gesehen werden. Selbstverständlich können die Leuchtflächen bzw. die von den Leuchtflächen ausgesendeten Lichtsignale auch von größerer Entfernung aus wahrgenommen werden, sofern die Sichtlinie nicht verdeckt ist. Der genannte Abstand der Halbkugeloberfläche zur Gehäusebaugruppe ist also ein Mindestabstand, ab dem eine Sichtbarkeit der ausgesendeten Lichtsignale von jedem Punkt der Halbkugeloberfläche aus gegeben ist.

Es kann auch vorgesehen sein, dass die Leuchtflächen jeweils so groß gestaltet sind, dass sie von der durch den halbkugelförmigen Bereich um die Gehäusebaugruppe definierten Halbkugeloberfläche aus durch ein durchschnittliches menschliches Auge als Objekt wahrgenommen werden können. Vereinfacht ausgedrückt kann also die Größe der Leuchtflächen mit dem Abstand der Halbkugeloberfläche zur Gehäusebaugruppe korrelieren. Als Korrelationsfaktor dient beispielsweise die Sehwinkelauflösung eines durchschnittlichen menschlichen Auges, welche den kleinsten Winkel beschreibt, unter dem zwei Punkte getrennt gesehen werden können. Der Korrelationsfaktor beträgt beispielsweise 60 Bogensekunden.

Konkret können, wenn der Abstand der durch den halbkugelförmigen Bereich um die Gehäusebaugruppe definierte Halbkugeloberfläche zur Gehäusebaugruppe 10 cm beträgt, Leuchtflächen vorgesehen sein, deren Größe, insbesondere deren Durchmesser oder Seitenlänge, mindestens 0,3 mm beträgt.

Bei einem Abstand der Halbkugeloberfläche zur Gehäusebaugruppe von 50 cm kann vorgesehen sein, dass die Größe der Leuchtflächen mindestens 1,5 mm beträgt.

Bei einem Abstand der Halbkugeloberfläche zur Gehäusebaugruppe von 1 m kann vorgesehen sein, dass die Größe der Leuchtflächen mindestens 3 mm beträgt.

Bei einem Abstand der Halbkugeloberfläche zur Gehäusebaugruppe von 5 m kann vorgesehen sein, dass die Größe der Leuchtflächen mindestens 1,5 cm beträgt.

Bei einem Abstand der Halbkugeloberfläche zur Gehäusebaugruppe von 10 m kann vorgesehen sein, dass die Größe der Leuchtflächen mindestens 3 cm beträgt.

Bei einem Abstand der Halbkugeloberfläche zur Gehäusebaugruppe von 50 m kann vorgesehen sein, dass die Größe der Leuchtflächen mindestens 15 cm beträgt.

Bei einem Abstand der Halbkugeloberfläche zur Gehäusebaugruppe von 100 m kann vorgesehen sein, dass die Größe der Leuchtflächen mindestens 30 cm beträgt.

Dadurch wird sichergestellt, dass betreffenden Leuchtflächen aus dem gegebenen Abstand durch ein durchschnittliches menschliches Auge jeweils als Objekt wahrgenommen werden können, was auch die Wahrnehmbarkeit der durch die Leuchtflächen ausgesendeten Signale insgesamt verbessert.

Der halbkugelförmige Bereich um die Gehäusebaugruppe umschließt wenigstens fünf Seiten der Gehäusebaugruppe, insbesondere vollständig, nämlich die Anschlussseite, die erste Längsseite, die zweite Längsseite, die erste Stirnseite und die zweite Stirnseite. Anders ausgedrückt ist beispielsweise nur die Unterseite, die zur Anschlussseite entgegengesetzt ist, nicht vom halbkugelförmigen Bereich um die Gehäusebaugruppe umschlossen.

In einer Variante sind die Leuchtflächen entlang der Gehäusebaugruppe derart verteilt angeordnet, dass eine Unterseite der Gehäusebaugruppe in einer durch den halbkugelförmigen Bereich definierten Kugelschnittfläche ebenfalls liegt. Dadurch wird eine besonders gute Sichtbarkeit der Leuchtflächen erreicht.

Es kann auch vorgesehen sein, dass die Leuchtanzeigen so angesteuert werden, dass das elektronische Gerät aktiv auf sich aufmerksam macht, um gefunden zu werden. Dies kann neben der Wartung auch bei der Installation von Vorteil sein. Beispielsweise kann das elektronische Gerät, welches mit einer weiteren Komponente verbunden werden soll, per Lichtsignal auf sich aufmerksam machen.

In diesem Zusammenhang ist auch denkbar, dass die Leuchtanzeigen dazu ausgebildet sind, ein Lichtsignal auf Anforderung auszugeben, um aufgefunden zu werden oder einen Status anzuzeigen.

Insofern wird über diese Leuchtflächen nur bestimmte Informationen optisch dargestellt, da die Leuchtflächen zur Rundumsichtbarkeit (360°-Sichtbarkeit) dienen, sodass beispielsweise der Status einzelner Module oder Eingaben/Ausgaben am elektronischen Gerät über eine Leuchte, bspw. eine LED, an der Anschlussseite ausgegeben wird. Die Leuchte ist dabei dem entsprechenden Anschuss zugeordnet.

Mit anderen Worten wird der Status einer über einen Anschluss hergestellten Verbindung nicht über die Leuchtanzeigen bzw. Leuchtflächen ausgegeben, sondern über wenigstens eine dem jeweiligen Anschluss zugeordnete Leuchte.

Die Leuchtanzeigen bzw. Leuchtflächen dienen vielmehr zur optischen Signalisierung eines Status des gesamten elektronischen Geräts, bspw. zur Auffindbarkeit des elektronischen Geräts, zur Wartungsanzeige oder zur Störungsanzeige.

In einer Ausführungsform der Gehäusebaugruppe sind die Leuchtflächen im Wesentlichen ebene Flächen. Dies ist technisch besonders einfach umsetzbar, sodass sich die Herstellungskosten reduzieren lassen.

Die Leuchtflächen können eine dreieckige Form haben. Dadurch kann eine gleichmäßig gute Sichtbarkeit bei Betrachtung des elektronischen Geräts von verschiedenen Seiten aus erreicht werden, wobei gleichzeitig die relative Fläche der Leuchtfläche möglichst klein gehalten wird.

In einer Variante der Erfindung besteht das Gehäuse aus einem undurchsichtigen bzw. einem lichtundurchlässigen (opaken) Material, beispielsweise aus einem Metall. In dem Fall sind nur die Leuchtflächen aus einem durchsichtigen bzw. lichtleitenden Material gefertigt. Beispielsweise sind die Leuchtflächen als Lichtleiter ausgebildet und/oder in das Gehäuse integriert. Das Gehäuse kann dann im Bereich der Leuchtflächen entsprechende Ausnehmungen für die Leuchtflächen aufweisen.

Die Leuchtflächen sind dabei entweder separat oder gemeinsam mit dem Gehäuse gefertigt. Es ist denkbar, dass die Leuchtflächen durch ein Spritzgießverfahren hergestellt sind. Es ist zudem insbesondere bei einem Zweikomponentenspritzgießverfahren denkbar, dass das Gehäuse und die Leuchtflächen in einem Herstellungsverfahren gemeinsam hergestellt werden, sodass beispielsweise die Leuchtflächen direkt an das Gehäuse angespritzt sind.

Alternativ oder zusätzlich kann die Gehäusewand zumindest teilweise aus einem lichtleitenden Material gebildet sein. Beispielsweise kann die Gehäusewand in den Bereichen der Leuchtflächen aus einem lichtleitenden Material bestehen. So kann eine Lichtquelle innerhalb des Gehäuses genutzt werden, um Licht zu generieren, welches dann über die Gehäusewand und die Leuchtflächen aus dem Gehäuse ausgekoppelt wird.

Durchbrüche in der Gehäusewand sind also nicht notwendig, um die Leuchtanzeigen zu realisieren. Dadurch wird sichergestellt, dass die elektronischen Komponenten im Gehäuseinneren des elektronischen Geräts gut geschützt sind, insbesondere gegenüber Wasser, Feuchtigkeit und/oder Staub, wobei dies vom jeweiligen Einsatzgebiet des elektronischen Geräts abhängt.

Es ist ferner denkbar, dass die Gehäusewand auch in leuchtflächenfernen Bereichen aus einem lichtleitenden Material gebildet ist. So kann Licht beabstandet von einer Leuchtfläche in die Gehäusewand eingekoppelt, entlang der Gehäusewand geleitet und durch die Leuchtflächen ausgekoppelt werden. Die Oberfläche der Gehäusewand kann dabei zumindest teilweise mit einer opaken Farbe versehen sein, bspw. beschichtet sein. Hierdurch ist sichergestellt, dass das Licht nur an gewünschten Bereichen austritt, nämlich den Leuchtflächen.

In einer Variante der Gehäusebaugruppe weist jede Leuchtanzeige zwei Leuchtflächen auf, die benachbart zueinander angeordnet sind, wobei die Leuchtflächen der gleichen Leuchtanzeige jeweils eine dreieckige Form haben und die Leuchtanzeige eine rechteckige Form hat. Über die benachbarten Leuchtflächen können verschiedene Lichtsignale über den gleichen Gehäusebereich ausgegeben werden, beispielsweise anhand unterschiedlicher Lichtfarben der zwei benachbarten Leuchtflächen. Beide Lichtsignale können dann von einem Betrachtungsort aus gleichzeitig wahrgenommen werden. Dadurch stehen am Betrachtungsort eine höhere Dichte an Lichtsignalen und somit auch mehr Informationen über den Zustand des elektronischen Gerätes zur Verfügung. Die Leuchtanzeige ist aufgrund der Form der Leuchtflächen dennoch kompakt.

Es kann vorgesehen sein, dass die Übergangsbereiche in abgeschrägten Eckbereichen eines ansonsten quaderförmigen Gehäuses vorgesehen sind, das die Anschlussseite, die Längsseiten sowie die Stirnseiten umfasst. Diese Anordnung hat sich als besonders platzsparend herausgestellt, wobei dennoch eine 360°-Sichtbarkeit gewährleistet ist. Die Anschlussseite, Längsseiten sowie die Stirnseiten stehen somit im Wesentlichen unverändert für andere Funktionen zur Verfügung, beispielsweise zur Kühlung des elektronischen Geräts oder zur Verknüpfung mit weiteren Komponenten.

In einer weiteren Variante der Gehäusebaugruppe sind vier Leuchtanzeigen in vier verschiedenen Übergangsbereichen vorgesehen. Diese können beispielsweise in vier Eckbereichen eines ansonsten quaderförmigen Gehäuses angeordnet sein. Dadurch kann für quaderförmige Gehäuse auf technisch einfache Weise eine Rundumsichtbarkeit der Leuchtanzeigen erzielt werden.

Die Leuchtflächen können so angeordnet sein, dass sie von einer der Stirnseiten aus betrachtet jeweils einen Winkel in einem Bereich von 15° bis 35° mit der bzw. den angrenzenden Längsseite(n) einschließen und/oder von einer der Längsseiten aus betrachtet einen Winkel in einem Bereich von 15° bis 35° mit der bzw. den angrenzenden Stirnseite(n) einschließen. Dadurch wird eine gleichmäßig gute Sichtbarkeit der Leuchtflächen bei Betrachtung des elektronischen Geräts von verschiedenen Seiten aus gewährleistet.

Es ist denkbar, dass die Leuchtflächen jeweils unter einem von 90° verschiedenen Winkel zu allen angrenzenden Gehäusewänden ausgerichtet sind. Auch dies verbessert deren Sichtbarkeit aus verschiedenen Betrachtungsrichtungen.

In einer Ausführungsform der Gehäusebaugruppe ist vorgesehen, dass die Leuchtflächen jeweils in einer Seitenansicht auf die Gehäusebaugruppe keilförmig ausgebildet sind, insbesondere in einer Frontansicht auf die zugeordnete Längsseite und/oder in einer Frontansicht auf die zugeordnete Stirnseite. Dadurch ist einfach zu erkennen, wie das elektronische Gerät orientiert ist, insbesondere wo die Anschlussseite liegt.

Um die Sichtbarkeit und/oder Bestimmbarkeit der Orientierung des elektronischen Geräts weiter zu verbessern, kann vorgesehen sein, dass die Leuchtflächen jeweils in einer Draufsicht auf die Gehäusebaugruppe dreieckig ausgebildet sind.

Die Aufgabe der Erfindung wird ferner gelöst durch ein elektronisches Gerät mit einer erfindungsgemäßen Gehäusebaugruppe und zumindest einer Lichtquelle, die in der Gehäusebaugruppe angeordnet und dazu ausgebildet ist, Licht auszusenden, welches durch die Leuchtflächen auskoppelt.

Die Vorteile, die zur erfindungsgemäßen Gehäusebaugruppe diskutiert wurden, gelten für das elektronische Gerät in gleicher Weise.

Das elektronische Gerät kann beispielsweise ein Feldgerät sein, insbesondere ein Feldbusmodul. Auch ist denkbar, dass das elektronische Gerät eine Kombination aus einem Feldbusmodul und einer Signalleuchte ist.

Die Lichtquelle kann beispielsweise eine zentrale in der Gehäusebaugruppe angeordnete LED sein. Auch der Einsatz mehrerer LEDs ist denkbar, insbesondere für den Fall, dass einfarbige LEDs vorgesehen sind.

Die mehreren LEDs können insbesondere dazu ausgebildet sein, Licht unterschiedlicher Wellenlänge bzw. Farbe auszusenden, um verschiedenfarbige Lichtsignale über die Leuchtanzeigen ausgeben zu können. Alternativ kann dieser Effekt auch durch eine Mehrfarbenleuchtdiode erreicht werden.

Außerdem kann vorgesehen sein, dass das elektronische Gerät eine Steuerung umfasst, die dazu ausgebildet ist, die mindestens eine Lichtquelle so anzusteuern, dass diese ein sich veränderndes Lichtsignal aussendet, wobei das sich verändernde Lichtsignal durch eine zeitliche Veränderung der Lichtintensität und/oder Lichtfarbe gekennzeichnet ist. Die zeitliche Variation kann graphisch aufgetragen beispielsweise die Form einer Glockenkurve oder Gaußverteilung haben.

Es kann unter anderem auch die Helligkeit, die Leuchtdauer, die Häufigkeit, die Farbe und/oder die Abstrahlrichtung eines oder mehrerer Lichtsignale variiert werden. Auch mehrere sich verändernde Parameter in Kombination sind denkbar, beispielsweise ein Farbwechsel in Kombination mit einem Lichtintensitätswechsel.

Die zeitlichen Veränderungen können unregelmäßig sein. Dies zieht in besonderem Maße die Aufmerksamkeit von Betrachtern auf das elektronische Gerät.

Die Steuerung kann auch dazu ausgebildet sein, die Lichtquelle so anzusteuern, dass sie Lichtsignale bevorzugt aussendet, welche dazu dienen, auf das elektronische Gerät aufmerksam zu machen, insbesondere bevorzugt zu Lichtsignalen, die dazu dienen, lediglich einen Gerätestatus des elektronischen Geräts anzuzeigen. Dies verbessert die Auffindbarkeit des elektronischen Geräts.

Informationen zu einzelnen Verbindungen, die über das elektronische Gerät realisiert sind, werden hingegen nicht über die Leuchtanzeigen bzw. Leuchtflächen ausgegeben.

Auch ist denkbar, dass die Steuerung dazu ausgebildet ist, die Lichtquelle so anzusteuern, dass in einem Normalzustand, also einem Zustand in dem keine Fehler vorliegen und/oder keine Wartung notwendig ist, kein Licht ausgesendet wird. Auch dadurch kann die Auffindbarkeit einzelner Geräte verbessert werden, insbesondere indem von benachbarten elektronischen Geräten stammende störende Lichtemissionen verringert werden. Außerdem kann so elektrische Energie beim Betrieb des elektronischen Geräts eingespart werden.

Ferner kann die Steuerung dazu ausgebildet sein, die Lichtquelle in Abhängigkeit eines äußeren Signals anzusteuern. Das äußere Signal kann beispielsweise von einem Nutzer oder Wartungspersonal vorgegeben werden. Die Steuerung kann dann basierend auf dem äußeren Signal die Lichtquelle aktivieren, insbesondere um das elektronische Gerät einfacher auffindbar zu machen.

Weitere Merkmale und Vorteile der Erfindung ergeben sich aus der nachfolgenden Beschreibung sowie aus den Zeichnungen, auf die Bezug genommen wird. In den Zeichnungen zeigen:
- Fig. 1 eine schematische dreidimensionale Darstellung eines ersten Ausführungsbeispiels eines Teils eines erfindungsgemäßen elektronischen Geräts;
- Fig. 2 eine schematische Darstellung eines zweiten Ausführungsbeispiels eines erfindungsgemäßen elektronischen Geräts in einer Stirnseitenansicht;
- Fig. 3 das elektronische Gerät aus Figur 2 in einer Anschlussseitenansicht bzw. Draufsicht;
- Fig. 4 das elektronische Gerät aus Figur 2 in einer Längsseitenansicht; und
- Fig. 5 eine schematische dreidimensionale Darstellung eines Ausschnittes eines dritten Ausführungsbeispiels eines erfindungsgemäßen elektronischen Geräts.

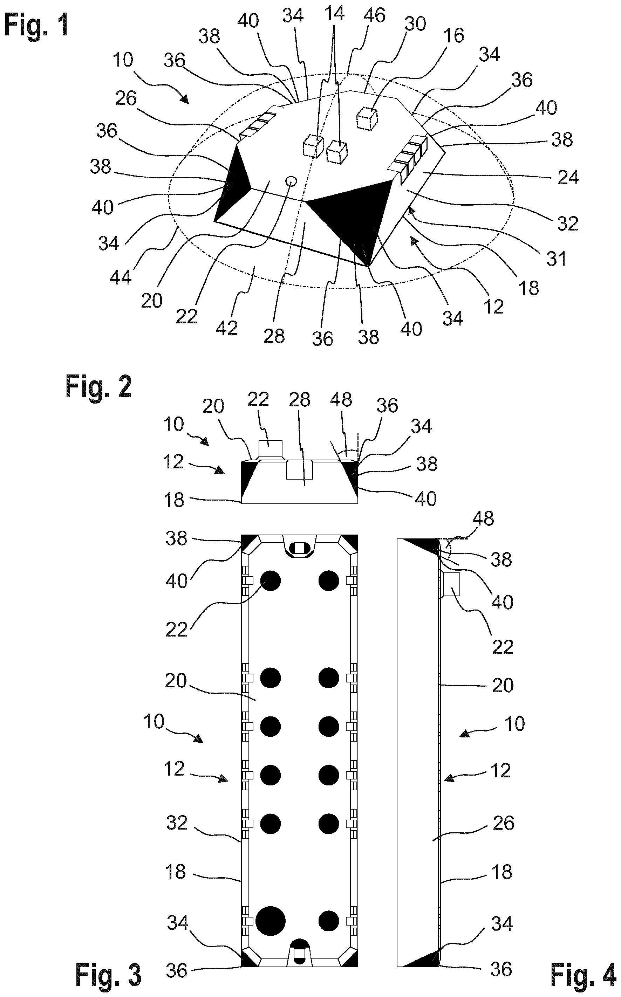

Figur 1 zeigt eine schematische Darstellung eines erfindungsgemäßen elektronischen Geräts 10.

Das elektronische Gerät 10 weist eine Gehäusebaugruppe 12 auf. Ferner weist das elektronische Gerät 10 zwei Lichtquellen 14 auf, beispielsweise Leuchtdioden, die Licht in unterschiedlicher Farbe aussenden können. Die Lichtquellen 14 sind in der Gehäusebaugruppe 12 angeordnet, weswegen sie vorliegend gestrichelt dargestellt sind.

Außerdem weist das elektronische Gerät 10 noch eine Steuerung 16 auf, welche ebenfalls in der Gehäusebaugruppe 12 angeordnet ist, weswegen die Steuerung 16 auch gestrichelt dargestellt ist. Die Steuerung 16 ist dazu ausgebildet, die zwei Lichtquellen 14 so anzusteuern, dass diese jeweils ein Lichtsignal aussenden.

Im Ausführungsbeispiel werden die Lichtquellen 14 so angesteuert, dass sich das ausgesendete Lichtsignal zeitlich verändert, insbesondere in seiner Lichtintensität und/oder Lichtfarbe. Beispielsweise können die beiden Lichtquellen 14 blinken, insbesondere abwechselnd. Das Blinken kann auch unregelmäßig erfolgen, also ohne festes zeitliches Muster.

Die Ansteuerung der Lichtquellen 14 durch die Steuerung 16 kann dabei automatisch erfolgen oder in Abhängigkeit eines von einem Nutzer vorgegebenen äußeren Signals bzw. Befehls.

Die Gehäusebaugruppe 12 umfasst ein Gehäuse 18 mit einer Anschlussseite 20, an der wenigstens ein Anschluss 22 vorgesehen ist, insbesondere mehrere Anschlüsse 22. Ferner umfasst das Gehäuse 18 eine erste Längsseite 24, eine zweite Längsseite 26, eine erste Stirnseite 28 und eine zweite Stirnseite 30 sowie eine Unterseite 31.

Die Seiten 20, 24, 26, 28 ,30, 31 weisen jeweils eine Gehäusewand 32 auf bzw. sind durch diese gebildet.

Die Längsseiten 24, 26 sind jeweils mit den Stirnseiten 28, 30 in Übergangsbereichen 34 verbunden. Auch die Übergangsbereiche 34 weisen jeweils eine Gehäusewand 32 auf bzw. sind durch diese gebildet.

Im Ausführungsbeispiel sind die Übergangsbereiche 34 in abgeschrägten Eckbereichen 36 des ansonsten quaderförmigen Gehäuses 18 vorgesehen. Mit anderen Worten würde das Gehäuse 18 ein Quader sein, sofern die Übergangsbereiche 34 nicht abgeschrägt wären.

Die Gehäusebaugruppe 12 umfasst in jedem der Übergangsbereiche 34 jeweils eine Leuchtanzeige 38. Insgesamt hat die Gehäusebaugruppe 12 demnach vier unterschiedliche Übergangsbereiche 34 und somit auch vier Leuchtanzeigen 38.

Mit anderen Worten sind also vier Leuchtanzeigen 38 vorgesehen, die in vier verschiedenen Übergangsbereichen 34 angeordnet sind.

Jede der Leuchtanzeigen 38 weist eine Leuchtfläche 40 auf. In jedem der Übergangsbereiche 34 befindet sich also eine der Leuchtflächen 40.

Im Ausführungsbeispiel sind die Leuchtflächen 40 durch die Gehäusewände 32 in den jeweiligen Übergangsbereichen 34 gebildet.

Die Gehäusewände 32 bestehen dazu zumindest in den Übergangsbereichen 34 aus einem lichtleitenden Material. Licht, welches durch die Lichtquellen 14 im Gehäuseinneren erzeugt wird, kann in den Übergangsbereichen 34 in die Gehäusewände 32 einkoppeln und über die Leuchtflächen 40 wieder aus den Gehäusewänden 32 nach außen hin auskoppeln, wodurch ein Lichtsignal ausgesendet wird.

Es ist ferner denkbar, dass die Gehäusewände 32 auch im Bereich der Anschlussseite 20, der ersten Längsseite 24, der zweiten Längsseite 26, der ersten Stirnseite 28, der zweiten Stirnseite 30 und/oder der Unterseite 31 aus einem lichtleitenden Material gebildet sind. Insbesondere können auch alle Gehäusewände 32 aus einem lichtleitenden Material bestehen. In Bereichen, in denen keine Leuchtflächen 40 vorgesehen sind, kann eine zusätzliche opake Schicht vorgesehen sein, beispielsweise eine Lackierung, die verhindert, dass das Licht in diesen Bereichen aus dem elektronischen Gerät 10 auskoppelt. Es ist also sichergestellt, dass das Licht nur an den gewünschten Stellen austritt, nämlich den Leuchtflächen 40.

Die Lichtquellen 14 müssen bei diesem Aufbau nicht zwingend in Bereichen der Leuchtanzeigen 38 bzw. Leuchtflächen 40 angeordnet sein. Auch eine (separat ausgebildete) Lichtleitung in den Gehäusewänden 32 entlang der Anschlussseite 20, der ersten Längsseite 24, der zweiten Längsseite 26, der ersten Stirnseite 28 und/oder der zweiten Stirnseite 30 ist möglich. Die Lichteinkopplung und Lichtauskopplung kann also örtlich getrennt voneinander an unterschiedlichen Positionen der Gehäusebaugruppe 12 erfolgen.

Selbstverständlich ist dies nicht einschränkend zu verstehen. Das Gehäuse 18 kann auch aus einem undurchsichtigen bzw. einem lichtundurchlässigen (opaken) Material gefertigt sein, beispielsweise aus einem Metall.

Die Leuchtflächen 40 sind entweder separat zum Gehäuse 18 oder gemeinsam mit dem Gehäuse 18 hergestellt. Beispielsweise können sie mittels eines Zweikomponentenspritzgießverfahrens direkt an das Gehäuse 18 angespritzt worden sein. Es ist aber auch denkbar, dass die Leuchtflächen 40 nachträglich in das Gehäuse 18 installiert worden sind.

Die Leuchtflächen 40 sind im Ausführungsbeispiel als ebene Flächen mit einer dreieckigen Form ausgebildet.

Zudem sind die Leuchtflächen 40 entlang der Gehäusebaugruppe 12 derart verteilt angeordnet, dass sie zusammen in einem aktivierten Zustand Lichtsignale in einen halbkugelförmigen Bereich 42 um die Gehäusebaugruppe 12 aussenden.

Der halbkugelförmige Bereich 42 ist in Figur 1 schematisch dargestellt. Er ist durch eine Halbkugeloberfläche 44 sowie eine Kugelschnittfläche 46 charakterisiert, welche zusammen die Grenzen bzw. die Größe des halbkugelförmigen Bereichs 42 festlegen.

Die Leuchtflächen 40 sind in dem in Figur 1 gezeigten Beispiel so angeordnet, dass die von ihnen ausgesendete Lichtsignale jeden Punkt der Halbkugeloberfläche 44 des halbkugelförmigen Bereich 42 erreichen.

Mit anderen Worten ist von jedem Punkt der die Gehäusebaugruppe 12 umgebenden Halbkugeloberfläche 44 aus zumindest eine der Leuchtflächen 40 sichtbar, sodass wenigstens ein von diesen Leuchtflächen 40 ausgesendetes Lichtsignal wahrgenommen werden kann.

Es besteht also eine direkte Sichtlinie zwischen jedem Punkt der durch den halbkugelförmigen Bereich 42 definierten Halbkugeloberfläche 44 und einer der Leuchtflächen 40.

Der Abstand der Gehäusebaugruppe 12 zur Halbkugeloberfläche 44 beträgt beispielsweise 10 cm, 50 cm, 1 m, 5 m, 10 m, 50 m oder 100 m. Zumindest von diesem Abstand aus können die Leuchtflächen 40 bzw. die von den Leuchtflächen 40 ausgesendeten Lichtsignale von jedem Punkt der Halbkugeloberfläche 44 aus gesehen werden. Selbstverständlich können die Leuchtflächen 40 bzw. die von den Leuchtflächen 40 ausgesendeten Lichtsignale auch von größerer Entfernung aus wahrgenommen werden.

In dem in Figur 1 gezeigten Beispiel umgibt der halbkugelförmige Bereich 42 die Gehäusebaugruppe 12 vollständig.

Dadurch wird eine gute Sichtbarkeit der Leuchtflächen 40 sichergestellt, selbst wenn das elektronische Gerät 10 nicht direkt von der Anschlussseite 20 aus betrachtet wird, sondern seitlich.

Die Figuren 2 bis 4 zeigen eine schematische Darstellung eines zweiten Ausführungsbeispiels eines erfindungsgemäßen elektronischen Geräts 10 in einer Stirnseitenansicht, Anschlussseitenansicht und Längsseitenansicht.

Das in den Figuren 2 bis 4 gezeigte elektronische Gerät 10 entspricht in mehreren wesentlichen Aspekten dem in Figur 1 gezeigten elektronischen Gerät 10, sodass im Folgenden lediglich auf die Unterschiede eingegangen wird. Gleiche und/oder funktionsgleiche Bauteile sind mit den gleichen Bezugszeichen versehen.

Bei dem in Figur 2 gezeigten elektronischen Gerät 10 sind die Leuchtflächen 40 der Gehäusebaugruppe 12 jeweils unter einem von 90° verschiedenen Winkel zu allen Gehäusewänden 32 der angrenzenden Seiten 20, 24, 26, 28, 30 des (quaderförmigen) Gehäuses 18 ausgerichtet. So kann jede der Leuchtflächen 40 stets von mehr als einer der Seiten 20, 24, 26, 28, 30 aus betrachtet gesehen werden.

Die Leuchtflächen 40 sind grundsätzlich so angeordnet, dass sie von einer der Stirnseiten 28, 30 aus betrachtet jeweils einen Winkel 48 von 25° mit den angrenzenden Längsseiten 24, 26 bilden. Gleichzeitig bilden sie von einer der Längsseiten 24, 26 aus betrachtet einen Winkel 48 von 25° mit den angrenzenden Stirnseiten 28, 30.

Dadurch kann erreicht werden, dass bei einer Betrachtung des elektronischen Gerätes 10 aus verschiedenen Richtungen die sichtbare Gesamtleuchtfläche (also die sichtbaren Anteile der jeweiligen Leuchtflächen 40 zusammengenommen) zumindest annähernd gleich ist.

Bildlich gesprochen sind bei einer Betrachtung des elektronischen Geräts 10 von einer der Stirnseiten 28, 30 aus (vgl. Fig. 2) oder von einer der Längsseiten 24, 26 aus (vgl. Fig. 4) nur zwei der vier Leuchtflächen 40 zu sehen. Die Leuchtflächen 40 sind in einer solchen Frontansicht auf eine der Längsseiten 24 26 und/oder Stirnseiten 28, 30 keilförmig ausgebildet.

Bei einer Betrachtung von der Anschlussseite 20 aus (vgl. Fig. 3) sind dagegen alle vier Leuchtflächen 40 zu sehen. Die Leuchtflächen 40 in einer solchen Draufsicht auf die Gehäusebaugruppe 12 sind jeweils dreieckig ausgebildet, insbesondere als gleichschenklige rechtwinklige Dreiecke.

Die sichtbare Gesamtleuchtfläche ist jedoch egal von welcher der Seiten 20, 24, 26, 28, 30 aus betrachtet immer zumindest annähernd gleich groß. Dadurch wird eine gute Sichtbarkeit ausgegebener Lichtsignale unabhängig von der Betrachtungsrichtung sichergestellt.

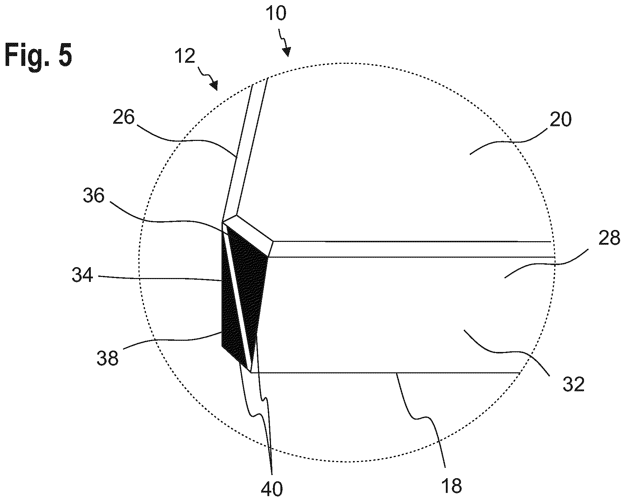

Figur 5 zeigt eine schematische dreidimensionale Darstellung eines Ausschnittes eines dritten Ausführungsbeispiels eines erfindungsgemäßen elektronischen Geräts 10.

Dieses entspricht in mehreren Aspekten den in den Figuren 1 bis 4 gezeigten elektronischen Geräten 10, sodass im Folgenden lediglich auf die Unterschiede eingegangen wird. Gleiche und/oder funktionsgleiche Bauteile sind mit den gleichen Bezugszeichen versehen.

Auch das elektronische Gerät 10 aus Figur 5 weist eine Gehäusebaugruppe 12 auf, die ein, bis auf abgeschrägte Eckbereiche 36, im Wesentlichen quaderförmiges Gehäuse 18 umfasst.

Die abgeschrägten Eckbereiche 36 sind auch gleichzeitig Übergangsbereiche 34.

Die Gehäusebaugruppe 12 umfasst im Ausführungsbeispiel vier Leuchtanzeigen 38. In jedem der Übergangsbereiche 34 ist dabei eine der Leuchtanzeigen 38 vorgesehen.

Besonders an dem elektronischen Gerät 10 aus Figur 5 ist, dass jede der Leuchtanzeigen 38 eine rechteckige Form hat und zwei Leuchtflächen 40 aufweist, die benachbart zueinander angeordnet sind und jeweils eine dreieckige Form haben.

Durch die im Vergleich zu den vorherigen Ausführungsbeispielen insgesamt größer Anzahl an Leuchtflächen 40, die von einem Betrachtungspunkt aus sichtbar sind, kann das elektronische Gerät 10 vielseitiger genutzt werden.

So ist denkbar, dass eine der benachbarten Leuchtflächen 40 dazu dient, die Aufmerksamkeit eines Betrachters auf das elektronische Gerät 10 zu lenken, beispielsweise indem sie blinkt, und die andere der benachbarten Leuchtflächen 40 als Anzeigeleuchte dient, beispielsweise um einen Betriebsstatus des elektronischen Geräts 10 und/oder einer Maschine oder Anlage anzuzeigen.

Zudem geht aus den Figuren hervor, dass den Anschlüssen 22 selbst jeweils Leuchten zugeordnet sind, die dazu dienen, den Status der über den jeweiligen Anschluss 22 hergestellten Verbindung anzuzeigen. Die Leuchten 20 können an den Rändern der Anschlussseite 20 vorgesehen sein, wie insbesondere aus Figur 3 deutlich wird.

Die Statusinformationen der über die Anschlüsse 22 hergestellten Verbindungen werden also nur über die an der Anschlussseite 20 vorgesehenen Leuchten ausgegeben, aber nicht über die Leuchtanzeigen 38 bzw. Leuchtflächen 40, die nur zur Ausgabe von Informationen bezüglich des gesamten elektronischen Geräts 10 dienen.

**Bezugszeichenliste**

| Bezugszeichen | Benennung |
|---|---|
| 10 | Elektronisches Gerät |
| 12 | Gehäusebaugruppe |
| 14 | Lichtquelle |
| 16 | Steuerung |
| 18 | Quaderförmiges Gehäuse |
| 20 | Anschlussseite |
| 22 | Anschluss |
| 24 | Erste Längsseite |
| 26 | Zweite Längsseite |
| 28 | Erste Stirnseite |
| 30 | Zweite Stirnseite |
| 31 | Unterseite |
| 32 | Gehäusewand |
| 34 | Übergangsbereich |
| 36 | Abgeschrägter Eckbereich |
| 38 | Leuchtanzeige |
| 40 | Leuchtfläche |
| 42 | Halbkugelförmiger Bereich |
| 44 | Halbkugeloberfläche |
| 46 | Kugelschnittfläche |
| 48 | Winkel |

## Patentansprüche

1. Gehäusebaugruppe für ein elektronisches Gerät (10), mit einer Anschlussseite (20), an der wenigstens ein Anschluss (22) vorgesehen ist, einer ersten Längsseite (24), einer zweiten Längsseite (26), einer ersten Stirnseite (28) und einer zweiten Stirnseite (30), wobei die Seiten (20, 24, 26, 28, 30) jeweils zumindest eine Gehäusewand (32) aufweisen, wobei die Längsseiten (24, 26) jeweils mit den Stirnseiten (28, 30) in Übergangsbereichen (34) verbunden sind, wobei die Gehäusebaugruppe (12) zumindest zwei Leuchtanzeigen (38) hat, wobei jede der Leuchtanzeigen (38) zumindest eine Leuchtfläche (40) aufweist, wobei eine erste der zumindest zwei Leuchtanzeigen (38) in einem ersten Übergangsbereich (34) vorgesehen ist, wobei eine zweite der zumindest zwei Leuchtanzeigen (38) in einem zweiten Übergangsbereich (34) vorgesehen ist, der vom ersten Übergangsbereich (34) unterschiedlich ist, und wobei die Leuchtflächen (40) entlang der Gehäusebaugruppe (12) derart verteilt angeordnet sind, dass die Leuchtflächen (40) zusammen in einem aktivierten Zustand Lichtsignale zumindest in einen halbkugelförmigen Bereich (42) um die Gehäusebaugruppe (12) aussenden.

2. Gehäusebaugruppe nach Anspruch 1, wobei die Leuchtflächen (40) im Wesentlichen ebene Flächen sind.

3. Gehäusebaugruppe nach Anspruch 1 oder 2, wobei die Leuchtflächen (40) eine dreieckige Form haben.

4. Gehäusebaugruppe nach einem der vorhergehenden Ansprüche, wobei die Gehäusewand bzw. Gehäusewände (32) zumindest teilweise aus einem lichtleitenden Material gebildet ist.

5. Gehäusebaugruppe nach einem der vorhergehenden Ansprüche, wobei jede Leuchtanzeige (38) zwei Leuchtflächen (40) aufweist, die benachbart zueinander angeordnet sind, wobei die Leuchtflächen (40) der gleichen Leuchtanzeige (38) jeweils eine dreieckige Form haben und die Leuchtanzeige (38) eine rechteckige Form hat.

6. Gehäusebaugruppe nach einem der vorhergehenden Ansprüche, wobei die Übergangsbereiche (34) in abgeschrägten Eckbereichen (36) eines ansonsten quaderförmigen Gehäuses (18) vorgesehen sind, das die Anschlussseite (20), die Längsseiten (24, 26) sowie die Stirnseiten (28, 30) umfasst.

7. Gehäusebaugruppe nach einem der vorhergehenden Ansprüche, wobei vier Leuchtanzeigen (38) in vier verschiedenen Übergangsbereichen (34) vorgesehen sind.

8. Gehäusebaugruppe nach einem der vorhergehenden Ansprüche, wobei die Leuchtflächen (40) so angeordnet sind, dass sie von einer der Stirnseiten (28, 30) aus betrachtet jeweils einen Winkel (48) in einem Bereich von 15° bis 35° mit der bzw. den angrenzenden Längsseite(n) (24, 26) einschließen und/oder von einer der Längsseiten (24, 26) aus betrachtet einen Winkel (48) in einem Bereich von 15° bis 35° mit der bzw. den angrenzenden Stirnseite(n) (28, 30) einschließen.

9. Gehäusebaugruppe nach einem der vorhergehenden Ansprüche, wobei die Leuchtflächen (40) jeweils unter einem von 90° verschiedenen Winkel zu allen Gehäusewänden (32) der angrenzenden Seiten (20, 24, 26, 28, 30) ausgerichtet sind.

10. Gehäusebaugruppe nach einem der vorhergehenden Ansprüche, wobei die Leuchtflächen (40) jeweils in einer Seitenansicht auf die Gehäusebaugruppe (12) keilförmig ausgebildet sind, insbesondere in einer Frontansicht auf die zugeordnete Längsseite (24, 26) und/oder in einer Frontansicht auf die zugeordnete Stirnseite (28, 30).

11. Gehäusebaugruppe nach einem der vorhergehenden Ansprüche, wobei die Leuchtflächen (40) jeweils in einer Draufsicht auf die Gehäusebaugruppe (12) dreieckig ausgebildet sind.

12. Elektronisches Gerät mit einer Gehäusebaugruppe (12) nach einem der vorhergehenden Ansprüche und zumindest einer Lichtquelle (14), die in der Gehäusebaugruppe (12) angeordnet und dazu ausgebildet ist, Licht auszusenden, welches durch die Leuchtflächen (40) auskoppelt.

13. Elektronisches Gerät nach Anspruch 12, umfassend eine Steuerung (16), die dazu ausgebildet ist, die Lichtquelle (14) so anzusteuern, dass diese ein sich veränderndes Lichtsignal aussendet, wobei das sich verändernde Lichtsignal durch eine zeitliche Veränderung der Lichtintensität und/oder Lichtfarbe gekennzeichnet ist, insbesondere wobei die zeitliche Veränderung unregelmäßig ist.
